# EUROPEAN PATENT SPECIFICATION

(11) **EP 0 380 091 B1**
(45) Date of publication and mention of the grant of the patent: **29.03.1995**
(21) Application number: 90101486.0
(22) Date of filing: 25.01.1990
(51) Int. Cl.: G11C 11/419

(54) **Static memory circuit provided with improved bit line precharging circuit**
Statische Speicherschaltung mit verbesserter Bitleitungs-Vorladeschaltung
Circuit de mémoire statique avec circuit de précharge pour lignes de bit

(30) Priority: 25.01.1989 JP 16773/89
(43) Date of publication of application: 01.08.1990
(73) Proprietor: NEC CORPORATION, Tokyo (JP)
(72) Inventor: Watanabe, Takayuki, Minato-ku, Tokyo (JP)
(74) Representative: Glawe, Delfs, Moll & Partner

(56) References cited:
- EP-A- 0 271 283
- US-A- 4 601 017
- US-A- 4 612 631
- US-A- 4 639 898
- US-A- 4 774 691

## Description

### BACKGROUND OF THE INVENTION

### Field of the Invention:

The present invention relates to a static memory circuit according to the preamble part of claim 1, more particularly to a bit line precharging circuit of a static memory circuit.

Such a static memory circuit is known from US-A- 4 639 898.

### Description of Related Arts:

Static memories have been widely utilized in various fields because they operate at a high speed without refresh operation. Such a static memory is constructed as follows. A plurality of static memory cells are arranged in a matrix form of rows and columns. A plurality of bit line pairs and a plurality of word lines are arranged in columns and rows, respectively. Each of the bit line pairs includes first and second bit lines coupled to the memory cells of the associated column in a balanced manner. Each pair of bit lines are precharged to the same precharge potential for example, a power voltage Vcc by a precharge circuit prior to a read operation. After the completion of the precharge of bit lines, one of the word lines is selected so that the memory cells coupled to the selected word line cause potential difference between the first and second bit lines in each of the bit line pairs. However, throughout the operation, each pair of bit lines are pulled-up to the power voltage Vcc for ensuring a high level by a pull-up circuit. Therefore, it is required before a selected memory cell is subjected to read-out operation that a selected pair of bit lines associated with the selected memory cell is made lower in potential. The speed for lowering the potentials at the bit lines is decreased by the pull-up function of the pull-up circuit which constantly supply a current to the bit lines.

### SUMMARY OF THE INVENTION

It is an object of the present invention to provide a semiconductor static memory which can produce a read out signal at a high speed.

This object is solved according to the invention by the features of claim 1.

According to the present invention, the pull-up circuit is temporarily disenabled to isolate the pair of bit lines from a source of the predetermined potential when one of the word lines is changed to the selective level, and therefore, the state of the pair of bit lines can be determined in accordance with the state of the selected memory rapidly without being enlarged in time by charges supplied through the pull-up circuit.

### BRIEF DESCRIPTION OF THE DRAWINGS

The above and other objects, the features and advantages of the present invention will become more apparent from the following description taken in conjunction with the accompanying drawings; wherein:
Fig. 1 is a schematic block diagram of a static memory in the prior art;
Fig. 2 is a timing diagram showing a read operation of the memory circuit of Fig. 1;
Fig. 3 is a schematic block diagram of a static memory according to one embodiment of the present invention;
Fig. 4 is a schematic circuit diagram of the timing signal generator employed in the memory of Fig. 3;
Fig. 5 is a timing diagram showing a read operation of the memory of Fig. 3;
Fig. 6 is a schematic block diagram of a static memory according to another embodiment of the present invention; and
Fig. 7 is a timing diagram showing an operation of the memory of Fig. 6.

### DETAILED DESCRIPTION OF THE INVENTION

### Description of the Prior Art:

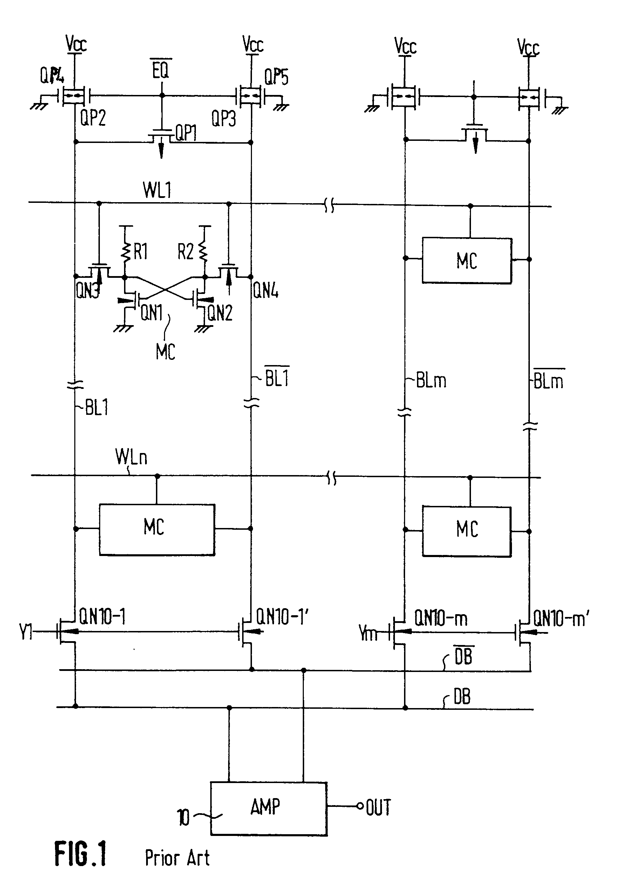

With reference to Fig. 1, the static memory circuit in the prior art will be explained.

A plurality of static type memory cells MC are arranged in a matrix form of "n" rows and "m" columns with n word lines WL₁ - WLₙ and m pairs of bit lines BL₁, B̅L̅₁̅ - BLₘ, B̅L̅ₘ̅ in a known way. Each of the memory cells MC includes a flip-flop composed of load resistors R1, R2 and N-channel MOS transistors Q_{N1}, Q_{N2} and a pair of N-channel transfer gate transistors Q_{N3} and Q_{N4}. A plural pairs of bit lines BL₁, B̅L̅₁̅ - BLₘ, B̅L̅ₘ̅ are connected to a pair of data lines DB, D̅B̅ through a plural pairs of N-channel column transfer gate transistors Q_{N10-1,} Q_{N10-1′} - Q_{N10-m,} Q_{N10-m′} which are controlled by column selection signals Y₁ - Yₘ. Also, as representatively shown for BL₁, B̅L̅₁̅, each pair of bit lines are provided with a precharge circuit composed of P-channel MOS transistors Q_{P1} - Q_{P3} having gates receiving a precharge control signal E̅Q̅ and a pull-up circuit composed of P-channel transistors Q_{P4} and Q_{P5} having gates connected to a ground potential.

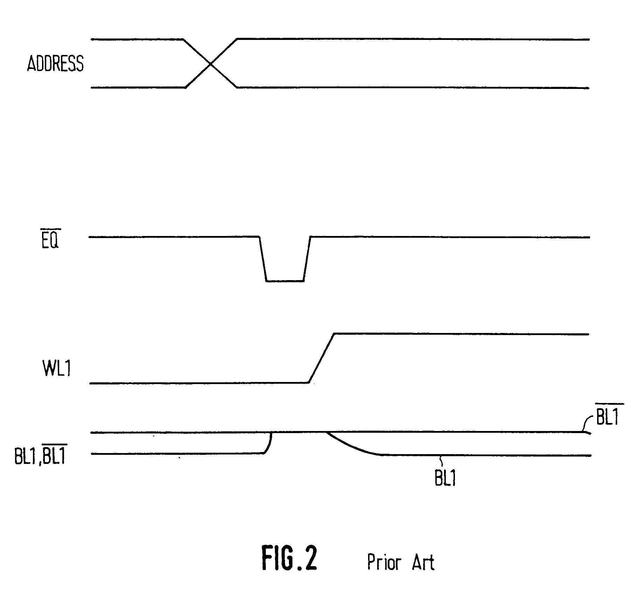

Operation of the conventional circuit of Fig. 1 will be described with reference to an internal operation waveform of Fig. 2.

The bit lines BL₁, B̅L̅₁̅ that have developed a potential difference in the preceeding cycle are precharged to Vcc by the precharge circuit (Q_{P1} - Q_{P3}) in response to a low level of the precharge signal E̅Q̅. One of the word lines is then activated after the completion of the precharging, and the electric charge of the bit line BL₁ is extracted by the memory cell to gradually develop a potential difference between the bit lines BL₁ and B̅L̅₁̅. Finally, the potential of the bit line BL₁ becomes a level determined by a series connection of the transistor Q_{P4} are the transistors Q_{N1} and Q_{N3}.

The P-channel transistors Q_{P4} and Q_{P5} for pulling up the bit lines are usually turned on continuously and do not permit the level of the bit line of the low potential side to become lower than a predetermined potential which is relatively near Vcc at the time of reading operation. Therefore, the time for precharging or equilizing the bit lines can be shortened. Furthermore, since the bit line does not become lower than a predetermined potential which is close to Vcc, the memory cell is not broken even when the word line is instantaneously selected due to noise.

Operation of the conventional memory circuit of Fig. 1 will be described with reference to Fig. 2.

However, the P-channel transistors Q_{P4} and Q_{P5} for pulling up the bit lines work to hinder the bit lines BL₁ and B̅L̅₁̅ from developing a potential difference. This tendency is particularly conspicuous when the word line WL is activated and a small potential difference between the bit lines BL₁ and B̅L̅₁̅ is transmitted to a sense amplifier 10 of the next stage.

It is considered that the memory capacity will further increase in future and the potential difference between the pair of bit lines becomes further small and the hindrance becomes no more negligible by the MOS transistors Q_{P4}, Q_{P5} that pull up the bit lines.

In the above-mentioned conventional semiconductor static memory in which the MOS transistors Q_{P4}, Q_{P5} that pull up the bit lines are turned on at all times, the electric charge of the bit lines is hindered from being extracted by the memory cell at the time of reading operation, and access is delayed.

### Description of the Embodiments:

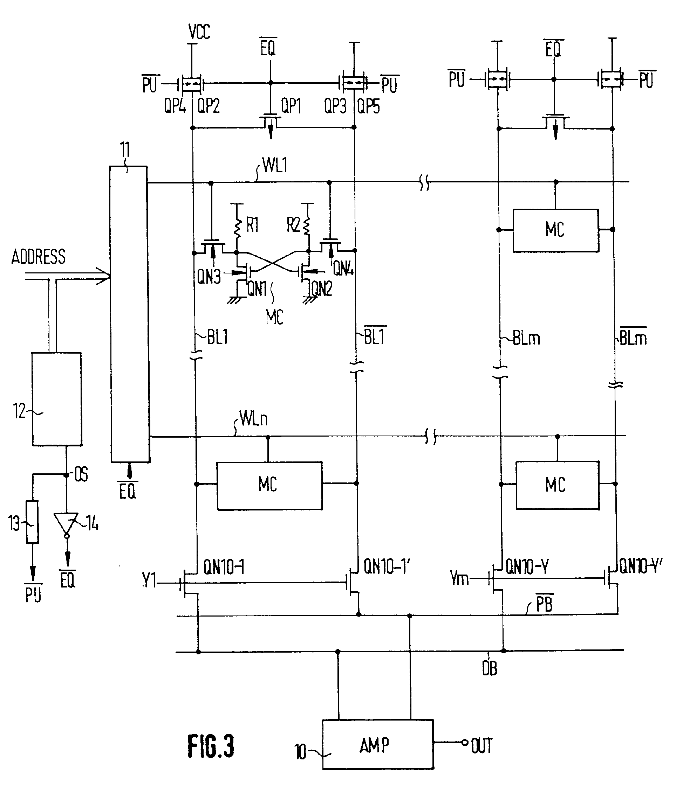

With reference to Figs. 3 to 5, the static memory circuit according to one embodiment of the present invention will be explained. In the following drawings, the elements or portions corresponding to those in Figs. 1 and 2 are denoted by the same or similar references and detailed explanation therefor will be omitted.

As shown in Fig. 3, the static memory circuit according to the present embodiment is featured in that each the pull-up circuit composed of the P-channel transistors Q_{P4} and Q_{P5} are controlled by a control signal P̅U̅ which assumes an inactive level when one of the word lines is selected by a row decoder 11 and an active level otherwise. In this memory, major control signals E̅Q̅ and P̅U̅ are generated by an address change detection circuit 12, a delay circuit 13 and an inverter 14. The control signal E̅Q̅ used for precharging the bit lines is also used to reset the row decoder 11 so that the operation of the row decoder 11 is inhibited.

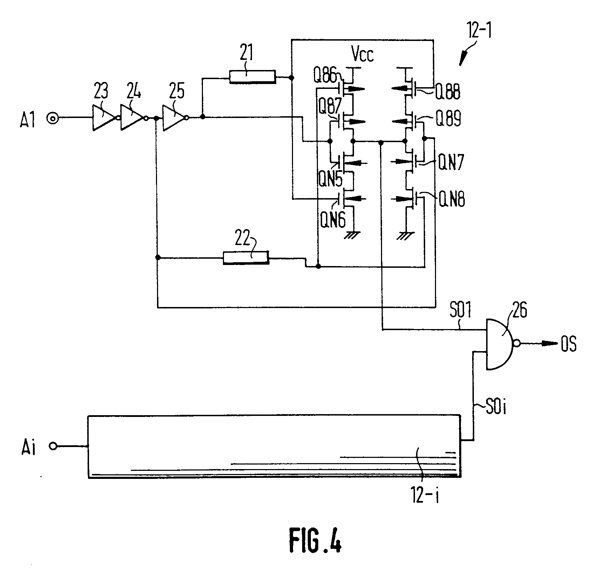

One example of the address change detection circuit 12 is shown in Fig. 4. The detection circuit 12 includes a plurality of detection units 12-1 to 12-i for the address input signals A₁ to Aᵢ, respectively. The detection unit 12-1 includes inverters 23-25, delay circuits 21, 22, N-channel transistors Q_{N5} - Q_{N8}, and P-channel transistors Q_{P6 -} Q_{P9}.

Outputs SO₁ - SOᵢ of the respective units 12-1 to 12-i are input to a NAND gate 26 from which a detection signal OS is generated.

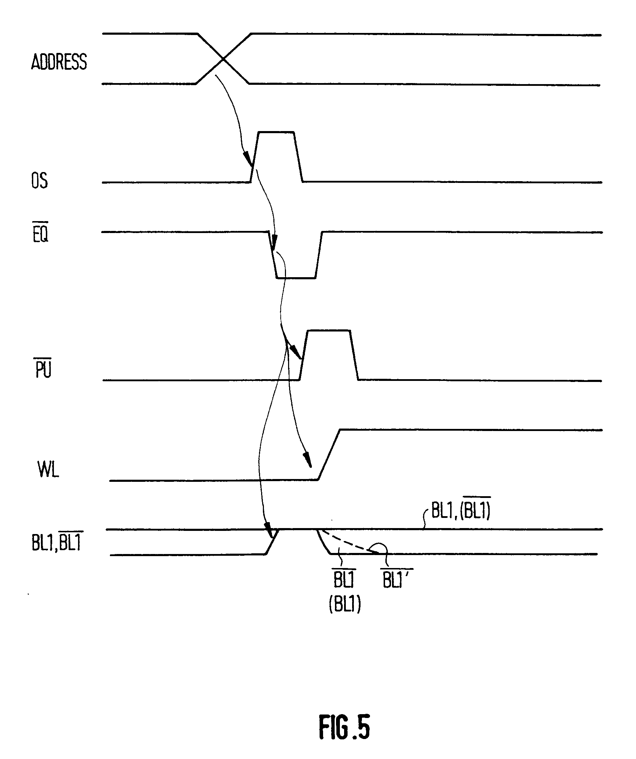

Next, operation of the present embodiment will be explained with reference to Fig. 5.

When the contents of the address signals ADDRESS are changed to terminate the previous cycle and to introduce a new cycle.

In response to the change in the address signals, the detection signal OS is generated from the detection circuit 12 and thereafter the control signal E̅Q̅ is also generated. Also, the control signal P̅U̅ is generated from the delay circuit 13 with a slight delay.

The bit lines BL₁, B̅L̅₁̅ that developed a potential difference in the previous cycle are precharged to Vcc by Q_{P1} - Q_{P3} in response to the active (low) level of E̅Q̅. The inactive (high) level of the signal P̅U̅ turns the transistors Q_{P4}, Q_{P5} non-conductive and the precharge signal E̅Q̅ becomes inactivated (rises) when the word line WL is activated. The transistors Q_{P1}, Q_{P2} are turned off during the period in which the potential difference develops on the bit lines BL₁, B̅L̅₁̅ based on logic levels "L" and "H" held by the memory cell MC as a result of activating the word line WL. In Fig. 5, a dotted line B̅L̅₁̅, indicates an operation waveform of the bit line in the case the transistors Q_{P4}, Q_{P5} for pulling up are turned on at all times according to prior art, and a solid line (B̅L̅₁̅) indicates an operation waveform of the bit line in the case the present invention is adopted. It will be obvious that the potential of the bit line is easily lowered by the memory cell and drops quickly (in Fig. 5, the potential of bit line B̅L̅₁̅ drops quickly) since the transistors Q_{P4}, Q_{P5} for pulling up are turned off in this instance.

After the data is transmitted from the bit line to a sense amplifier 10 of the next stage, the signal P̅U̅ turns on the transistors Q_{P4}, Q_{P5} for pulling up.

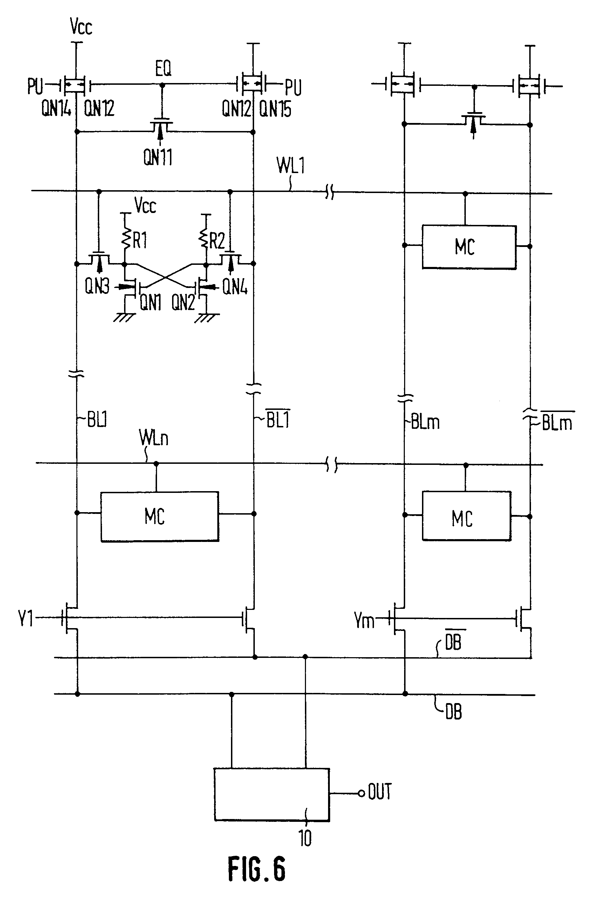

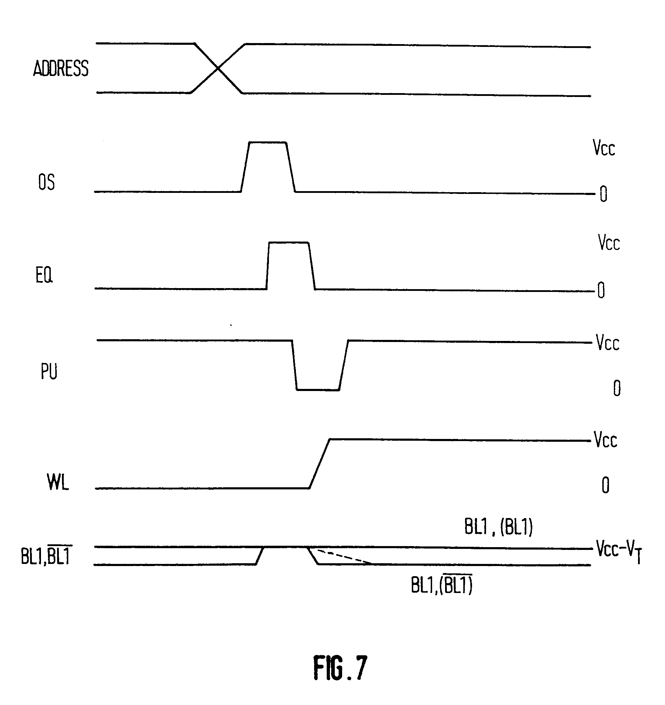

Fig. 6 is a circuit diagram which illustrates a second embodiment of the present invention, and Fig. 7 is a waveform diagram which illustrates the operation of the embodiment of Fig. 6.

What makes the embodiment of Fig. 6 different from that of Fig. 3 is that the transistors for pulling up and for precharging are the n-type MOS transistors Q_{N11} - Q_{N14} only. Therefore, the signal PU applied to the gates of Q_{N14}, Q_{N15} and the signal EQ applied to the gates of Q_{N11} - Q_{N13} are in the opposite in phase to the signal P̅U̅ and E̅Q̅ of Fig. 3, respectively.

Since the N-channel transistors are fused to pull up and precharge the bit lines, the precharging potential becomes V_{CC} - V_{T} (V_{T} denotes the threshold voltage of the N-channel transistor). During the period in which the word line WL is activated and the memory cell produces a potential difference between the bit lines BL₁ and B̅L̅₁̅, and the signal PU becomes inactive (low) and the N-channel transistors Q_{N14} and Q_{N15} for pulling up are turned off.

Therefore, the bit line BL₁ (B̅L̅₁̅) drops from V_{CC} - V_{T} without being hindered by the N-channel transistor Q_{N14} (Q_{N15}) for pulling up. As the signal PU is activated, the transistors Q_{N14} and Q_{N15} for pulling up are turned on, and the bit lines BL₁, B̅L̅₁̅ do not become lower than the predetermined potential.

According to the present invention as explained in the foregoing, the MOS transistors for pulling up the bit lines are turned off during the period in which the word line is activated, making it possible to quicken the dropping speed of the bit line. It is therefore possible to increase the reading speed of the semiconductor static memory.

Though the present invention has dealt with the transistors for pulling up the bit lines, it is also allowable to adapt the present invention to the data buses when they need be pulled up.

## Claims

1. A static memory circuit comprising a pair of bit lines (BL,B̅L̅), a plurality of word lines (WL) intersecting with said pair of bit lines, a plurality of static type memory cells (MC) coupled to said word lines and said bit lines, a word line selection circuit for selectively setting one of said word lines (WL) at a selective level in response to address signals, a pull-up circuit (QP4,QP5) for operatively pulling up potentials of said pair of bit lines (BL,B̅L̅) towards a predetermined potential, and first control means (P̅U̅) for disabling said pull-up circuit (QP4,QP5) during a first period through which a word line (WL) to be selected changes from the non-selected to the selected state so that said pull-up circuit is maintained inactive only for an initial portion of the period in which the word line is at its active state,
characterized by further comprising a precharge circuit (QP1-QP3) for operatively precharging said pair of bit lines (BL,B̅L̅) to said predetermined potential and second control means (EQ) for disabling said precharge circuit when a word line is activated and before the pull up means are activated by the first control circuit.

2. The static memory circuit according to claim 1, in which said pull-up circuit includes a first field effect transistor (QP4) having a current path coupled between one (BL) of said pair of bit lines and a power voltage terminal (Vcc) and a second field effect transistor (QP5) having a current path coupled between the other (B̅L̅) of said pair of bit lines and said power voltage terminal (Vcc).

3. The static memory circuit according to claim 1, further comprising a detection circuit (12) for detecting change in the contents of said address signals and means responsive to an output (SO) of said detection circuit for controlling said first control means.

4. The static memory circuit according to claim 1, in which said precharge circuit includes a first field effect transistor having a current path coupled between said pair of bit lines (BL,B̅L̅), and second and third field effect transistors having current paths coupled between a power voltage terminal and said pair of bit lines, respectively.

## Patentansprüche

1. Statische Speicherschaltung mit einem Paar von Bitleitungen (BL, BL), einer Vielzahl von Wortleitungen (WL), die das Paar von Bitleitungen schneiden, einer Vielzahl von statischen Speicherzellen (MC), die mit den Wortleitungen und den Bitleitungen gekoppelt sind, einer Wortleitungsauswahlschaltung zum wahlweisen Setzen einer der Wortleitungen (WL) auf einen wahlweisen Pegel in Antwort auf Adressignale, einer Pull-up-Schaltung (QP4, QP5) zum betriebsmäßigen Hochziehen des Potentials des Paares der Bitleitungen (BL, BL) auf ein vorbestimmtes Potential, und einer ersten Steuervorrichtung (PU) zum Deaktivieren der Pull-up-Schaltung (QP4, QP5) während einer ersten Zeitspanne, während welcher die auszuwählende Wortleitung (WL) vom nichtgewählten zum gewählten Zustand sich ändert, so daß die Pull-up-Schaltung unaktiv bleibt nur für einen Anfangsteil der Zeitspanne, in welcher die Wortleitung in ihrem aktiven Zustand ist,
dadurch **gekennzeichnet**, daß sie ferner aufweist eine Vorladeschaltung (QP1-QP3) zum betriebsmäßigen Vorladen des Paares der Bitleitungen (BL, BL) auf das vorbestimmte Potential und
eine zweite Steuervorrichtung (EQ) zum Deaktivieren der Vorladeschaltung, wenn eine Wortleitung aktiviert ist und bevor die Pull-up-Vorrichtungen durch die erste Steuerschaltung aktiviert werden.

2. Statische Speicherschaltung nach Anspruch 1, bei welcher die Pull-up-Schaltung einen ersten Feldeffekttransistor (QP4) aufweist, dessen Strompfad gekoppelt ist zwischen einer (BL) vom Paar der Bitleitungen und einem Spannungsversorgungsanschluß (Vcc), und einen zweiten Feldeffekttransistor (QP5), dessen Strompfad gekoppelt ist zwischen der anderen (BL) vom Paar der Bitleitungen und dem Spannungsversorgungsanschluß (Vcc).

3. Statische Speicherschaltung nach Anspruch 1, welche ferner aufweist eine Detektierschaltung (12) zum Detektieren einer Änderung im Inhalt der Adressignale und eine Vorrichtung, die in Antwort auf ein Ausgangssignal (SO) der Detektierschaltung die erste Steuervorrichtung steuert.

4. Statische Speicherschaltung nach Anspruch 1, bei welcher die Vorladeschaltung aufweist einen ersten Feldeffekttransistor, dessen Strompfad gekoppelt ist zwischen dem Paar der Bitleitungen (BL, BL), und einen zweiten und dritten Feldeffekttransistor, deren Strompfade gekoppelt sind zwischen einem Spannungsversorgungsanschluß bzw. dem Paar von Bitleitungen.

## Revendications

1. Circuit de mémoire statique comprenant une paire de lignes de bit (BL, B̅L̅ ), une pluralité de lignes de mot (WL) croisant ladite paire de lignes de bit, une pluralité de cellules de mémoire du type statique (MC) couplées auxdites lignes de mot et auxdites lignes de bit, un circuit de sélection de ligne de mot pour établir sélectivement l'une desdites lignes de mot (WL) à un niveau de sélection en réponse à des signaux d'adresse, un circuit d'amenée (QP4, QP5) pour amener en fonctionnement des potentiels de ladite paire de lignes de bit (BL, B̅L̅ ) vers un potentiel prédéterminé et un premier moyen de commande ( P̅U̅ ) pour invalider ledit circuit d'amenée (QP4, QP5) pendant une première période pendant laquelle une ligne de mot (WL) qui doit être sélectionnée passe de l'état non sélectionné à l'état sélectionné de telle sorte que ledit circuit d'amenée soit maintenu inactif seulement pendant une partie initiale de la période pendant laquelle la ligne de mot est dans son état actif,
caractérisé en ce qu'il comprend en outre un circuit de précharge (QP1-QP3) permettant de précharger en fonctionnement ladite paire de lignes de bit (BL, B̅L̅ ) audit potentiel prédéterminé et un second moyen de commande (EQ) pour invalider ledit circuit de précharge lorsqu'une ligne de mot est activée et avant que le moyen d'amenée ne soit activé par le premier circuit de commande.

2. Circuit de mémoire statique selon la revendication 1, dans lequel ledit circuit d'amenée inclut un premier transistor à effet de champ (QP4) comportant une voie de courant couplée entre l'une (BL) de ladite paire de lignes de bit et une borne de tension d'alimentation (Vcc) et un second transistor à effet de champ (QP5) comportant une voie de courant couplée entre l'autre (B̅L̅ ) de ladite paire de lignes de bit et ladite borne de tension d'alimentation (Vcc).

3. Circuit de mémoire statique selon la revendication 1, comprenant en outre un circuit de détection (12) pour détecter une modification des contenus desdits signaux d'adresse et un moyen sensible à une sortie (SO) dudit circuit de détection pour commander ledit premier moyen de commande.

4. Circuit de mémoire statique selon la revendication 1, dans lequel ledit circuit de précharge inclut un premier transistor à effet de champ comportant une voie de courant couplée entre ladite paire de lignes de bit (BL, B̅L̅ ) et des second et troisième transistors à effet de champ comportant des voies de courant couplées respectivement entre une borne de tension d'alimentation et ladite paire de lignes de bit.
